# EUROPÄISCHE PATENTSCHRIFT

(11) **EP 1 035 655 B1**
(45) Veröffentlichungstag und Bekanntmachung des Hinweises auf die Patenterteilung: **29.10.2003**
(21) Anmeldenummer: 00104277.9
(22) Anmeldetag: 01.03.2000
(51) Int. Cl.: H03L 7/093

(54) **Schaltungsanordnung in einem PLL Filter zum Erzeugen des Steuerpotentials für einen Feldeffekttranssistor im VCO**
Circuit in a PLL filter for generating a control voltage for a field-effect transistor in the VCO
Circuit dans un filtre de PLL pour générer une tension de commande pour un transistor à effet de champ dans un VCO

(30) Priorität: 05.03.1999 DE 19909736
(43) Veröffentlichungstag der Anmeldung: 13.09.2000
(73) Patentinhaber: Micronas GmbH, 79108 Freiburg (DE)
(72) Erfinder: Theus, Ulrich, Dr., 79194 Gundelfingen (DE)
(74) Vertreter: Schaumburg, Thoenes & Thurn

(56) Entgegenhaltungen:
- DE-A- 19 634 084
- US-A- 4 559 505
- US-A- 5 144 156

## Beschreibung

Die Erfindung betrifft eine Schaltungsanordnung zum Erzeugen des Steuerpotentials für einen Feldeffekttransistor aus der Ausgangsspannung einer Filterschaltung.

Eine Filterschaltung wird zum Erzeugen des Steuerpotentials für einen Feldeffekttransistor verwendet, wenn die das Steuerpotential bestimmende Größe in Form von Stromimpulsen verfügbar ist. Zum Ableiten des Steuerpotentials aus diesen Stromimpulsen ist eine Filterschaltung erforderlich, die eine Kapazität enthält und die Stromimpulse durch Aufladen der Kapazität glättet. An der Kapazität entsteht dann eine Filterausgangsspannung, die das Steuerpotential für den Feldeffekttransistor liefert. Ein derartiges Prinzip wird z.B. in Phasenregelschleifen angewendet, deren Oszillator an der Steuerelektrode eines Feldeffekt-Eingangstransistors gesteuert wird.

Die Stabilität der Arbeitsweise einer Phasenregelschleife erfordert es, daß die Filterschaltung außer Kondensatoren auch noch einen Widerstand enthält. Das thermische Rauschen dieses Widerstands bestimmt das Phasenrauschen des Oszillators, wenn die Filterschaltung so hochohmig ausgelegt wird, wie es entsprechend der hohen Eingangsimpedanz des Feldeffekttransistors im Sinne eines geringen Flächenverbrauchs in integrierter Schaltungstechnik vorteilhaft ist. Reduziert man den Widerstandswert zur Rauschminderung, dann wachsen die Kondensatoren im gleichen Verhältnis an und sind dann nicht mehr kostengünstig integrierbar.

Eine Möglichkeit zum Umgehen dieses Problems insbesondere bei LC-Oszillatoren besteht darin, daß die Steuerkennlinie des Oszillators einen möglichst flachen Verlauf hat. So ist es beispielsweise in FM-Abstimmschaltungen üblich, mit einem Spannungshub von 30 Volt die Frequenz um nur 20 % zu verstellen. Das erfordert einen besonderen Abgleich des Oszillators, da dieser Verstellbereich die Produktionstoleranzen nicht einschließt.

In integrierten Schaltungen sind RC-Oszillatoren oder Kippschaltungen üblich, die wegen der Miniaturisierung nur Betriebs- und Abstimmspannungen von höchstens 5 Volt zulassen und einen weiten Verstellbereich haben sollen, der neben dem erforderlichen Frequenzbereich auch noch die Produktionstoleranzen einschließen soll. Eine große Steilheit der Steuerkennlinie des Oszillators ist dann unvermeidlich.

Aus den deutschen Offenlegungsschriften DE 196 34 084 A1 und DE 197 13 058 A1 sind Phasenregelkreise bekannt. Bei dem Phasenregelkreis DE 196 34 084 A1 wird ein kapazitiver Spannungsteiler zur Unterdrückung von Störsignalen verwendet. Parallel zu dem einen Kondensator des Spannungsteilers liegen zwei Dioden mit zueinander entgegengesetzten Durchlaßrichtungen. Im Durchlaßbetrieb überbrückt eine der Dioden den Kondensator, so daß der am Ausgang der Filterschaltung fließende Strom im Verhältnis 1:1 als Umladestrom verwendet wird. Die Ausgangsspannung der Filterschaltung wird auf einen kapazitiven Spannungsteiler geführt, dessen Abgriff das Steuerpotential führt. Nachteilig ist, daß der Phasenregelkreis seine Übertragungseigenschaften ändert, wenn eine der Dioden den Kondensator des Spannungsteilers überbrückt.

Es ist Aufgabe der Erfindung, zum Erzeugen des Steuerpotentials für einen Feldeffekttransistor unter Verwendung eines kapazitiven Spannungsteilers eine verbesserte Schaltungsanordnung anzugeben.

Bei der Erfindung ist während des Über- bzw. Unterschreitens einer vorgegebenen oberen bzw. unteren Filterausgangsspannung ein mit dem Filterausgang verbundener Stromzweig wirksam schaltbar, der den Filterausgang mit einem die Filterausgangsspannung absenkenden bzw. anhebenden Strom belastet. Das Stromverhältnis von Umladestrom und dem Strom im mit dem Filterausgang verbundenen Stromzweig ist so bemessen, daß das Verhältnis eines Stroms am Eingang oder Ausgang der Filterschaltung und der Änderung des Potentials am Abgriff des Spannungsteilers in allen Betriebsarten der Schaltungsanordnung etwa denselben Wert hat.

Der Stromfluß in dem mit dem Filterausgang verbundenen Stromzweig verhindert, daß die das Filter treibende Schaltung ihren zulässigen Ausgangsspannungsbereich verläßt. Damit aber die Spannung am Abgriff des Spannungsteilers sich trotzdem so verstellt, wie wenn die Spannung am Filterausgang unbegrenzt wäre, wird ein Teil des Stroms mit umgekehrten Vorzeichen zur Kompensation in den Abgriff weitergeleitet, so daß sich dieser möglichst unabhängig davon verstellt, ob die Filterausgangsspannung einen Grenzwert erreicht hat oder nicht. Dadurch wird der einstellbare Spannungsbereich am Abgriff wesentlich größer als der der möglichen Variation der Filterausgangsspannung entsprechende Bereich.

Bei einer Weiterbildung der erfindungsgemäßen Schaltung ist der vorgegebene Wert fest gegenüber Massepotential und/oder einem Versorgungspotential vorgegeben.

Der Umladestrom und der Strom in dem mit dem Filterausgang verbundenen Stromzweig stehen in einem vorgegebenen Stromverhältnis, das kleiner als 1:10, vorzugsweise etwa 1:1000 ist. Während der Strom im mit dem Filterausgang verbundenen Stromzweig beispielsweise im Microamperebereich liegen sollte, um unerwünscht große Umladevorgänge am kapazitiven Spannungsteiler zu verhindern, genügt ein am Abgriff einzuspeisender Strom von wenigen Nanoampere, um das Steuerpotential für den Feldeffekttransistor in oben beschriebener Weise zu korrigieren.

Die n-Kanal-Umladeschaltung bei der Weiterbildung gemäß Anspruch 7 kann zwei einem Stromspiegel ähnliche Stromzweige enthalten, bei denen die Arbeitsstreckenanschlüsse ihrer beiden Transistoren nicht miteinander verbunden sind. Der eine Arbeitsstreckenanschluß liegt auf einem ersten Festpotential, der andere Arbeitsstreckenanschluß ist mit dem Filterausgang verbunden. Damit wird der Stromspiegel erst wirksam, wenn das Potential am Filterausgang das erste Festpotential erreicht. Der erste Stromzweig der n-Kanal-Umladeschaltung bestimmt den Stromfluß in dem mit dem Filterausgang verbundenen Stromzweig. Der zweite Stromzweig bestimmt den Umladestrom am Abgriff des kapazitiven Spannungsteilers.

Durch das Verwenden desselben am Festpotential liegenden Transistors für beide stromspiegelähnliche Stromzweige lassen sich Bauteile einsparen. Das vorgegebene Stromverhältnis von Umladestrom und Strom im Stromzweig am Ausgang der Filterschaltung wird durch einen Widerstand ermöglicht. Um das Stromverhältnis weiter zu verringern, kann auch das Breite/Längeverhältnis der Kanäle in den Transistoren der beiden stromspiegelähnlichen Stromzweige unterschiedlich sein.

Bei der Ausgestaltung nach Anspruch 8 hat die Umladeschaltung gleichfalls zwei einem Stromspiegel ähnliche Stromzweige. Der eine Arbeitsstreckenanschluß eines Transistors liegt dabei auf einem zweiten Festpotential. Der Arbeitsstreckenanschluß des anderen Transistors ist mit dem Ausgang der Filterschaltung verbunden. Die Schaltungsanordnung arbeitet als Stromspiegel, sobald das Potential am Ausgang der Filterschaltung das zweite Festpotential erreicht. Die p-Kanal-Umladeschaltung enthält außerdem zwei in Serie geschaltete Stromspiegelanordnungen, deren Verbindung mit dem Abgriff des kapazitiven Spannungsteilers das Einspeisen des Umladestroms ermöglicht. Um das vorgegebene Stromverhältnis zwischen Umladestrom und Strom im mit dem Filterausgang verbundenen Stromzweig zu erzielen, wird ein weiterer Widerstand verwendet, der im Ausgangsstromzweig des zweiten Stromspiegels angeordnet ist und mit einem vorgegebenen Strom gespeist wird.

Im folgenden wird ein Ausführungsbeispiel der Erfindung an Hand der Zeichnungen erläutert. Darin zeigen:
- Fig. 1: ein Prinzipschaltbild, und
- Fig. 2: eine Schaltungsanordnung, die sich zum Aufbau in integrierter MOS-Technik eignet.

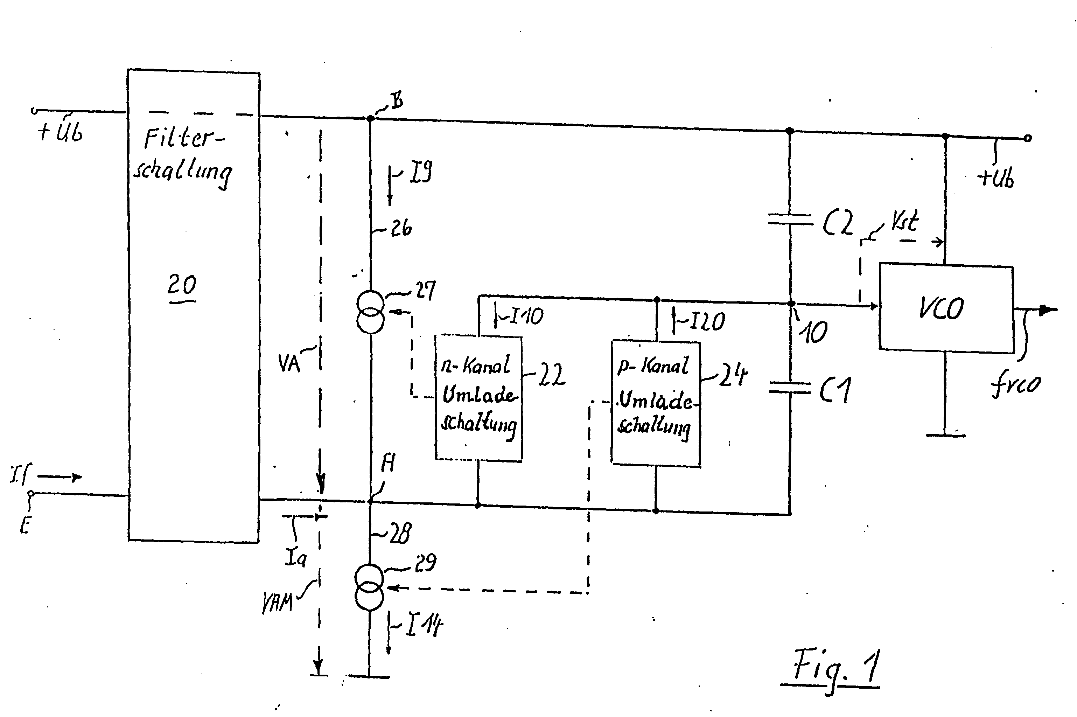

Die in Fig. 1 gezeigte Schaltungsanordnung ist Bestandteil einer PLL-Regelschleife (nicht dargestellt), mit der eine phasenstarre Kopplung zweier Signale erzeugt werden soll. Ein Ist-Signal fvco wird von einem spannungsgesteuerten Oszillator VCO abgegeben, dessen Steuereingang - beispielsweise ein p-Kanal-Transistor - am Ausgang der Schaltungsanordnung zwischen dem positiven Betriebsspannungspotential +Ub und dem Abgriff 10 eines kapazitiven Spannungsteilers aus Kapazitäten C1 und C2 liegt und der mit Massepotential als Bezugspotential verbunden ist. In einer nicht dargestellten Vergleichsschaltung der PLL-Regelschleife wird das Ist-Signal fvco als Meßgröße mit einem vorgegebenen Soll-Signal als Führungsgröße verglichen. Abhängig vom Phasenunterschied der beiden Signale wird am Ausgang der Vergleichsschaltung eine Stromimpulsfolge If erzeugt. Je längere Stromimpulse pro Zeiteinheit von z.B. 1 Millisekunde auftreten, um so größer ist die Phasenabweichung der beiden Signale. Ist dabei die Phase des Ist-Signals fvco voreilend gegen die Phase des Soll-Signals, so haben die Stromimpulse If der Vergleichsschaltung eine erste Richtung. Ist dagegen die Phase des Ist-Signals fvco nacheilend gegen die Phase des Soll-Signals, so haben diese Stromimpulse die entgegengesetzte Richtung.

Eine Filterschaltung 20 enthält Kapazitäten und glättet die Stromimpulsfolge If. Zwischen den Ausgangsanschlüssen A und B der Filterschaltung 20 entsteht eine geglättete Filterausgangsspannung VA, und es kann gegebenenfalls ein geglätteter Abgleichstrom la fließen. Falls erforderlich, wird auch die auf Masse bezogene Filterausgangsspannung VAM in der Beschreibung verwendet.

Die Filterausgangsspannung VA wird an dem kapazitiven Spannungsteiler geteilt, dessen Kapazitätsverhältnis so bemessen ist, daß an dessen Abgriff 10 ein Steuerpotential für den Eingangstransistor des VCO erscheint, das dessen Gate-Source-Spannung gegenüber den hochfrequenten Signalanteilen der Filterausgangsspannung VA auf etwa 1 % herabsetzt. Mit demselben Verhältnis ist dann auch der beschriebene Störanteil herabgesetzt. Beispielsweise Werte für C1 und C2 sind 0,4 pF und 40 pF.

Die in Fig. 1 gezeigte Schaltungsanordnung enthält einen dem Filterausgang parallel geschalteten Stromzweig 26, der in den Ausgangsanschluß A und damit in den Eingang des kapazitiven Spannungsteilers einen Strom 19 einspeist, wenn er durch eine gesteuerte Stromquelle 27 geschlossen wird. Diese wird durch eine n-Kanal-Umladeschaltung 22 in noch zu beschreibender Weise angesteuert, welche einen Strom I10 von dem Abgriff 10 des Spannungsteilers abziehen kann.

Ein weiterer Stromzweig 28 ist zwischen den Filterausgangsanschluß A und Massepotential geschaltet und entnimmt dem Ausgangsanschluß A und damit dem Eingang des kapazitiven Spannungsteilers C1, C2 einen Strom 114, wenn eine gesteuerte Stromquelle 29 aufgesteuert wird. Diese wird durch eine p-Kanal-Umladeschaltung 24 in noch zu beschreibender Weise angesteuert, welche dem Abgriff 10 des Spannungsteilers einen Strom 120 zuführen kann.

Die in Fig. 1 gezeigte Schaltungsanordnung arbeitet folgendermaßen:

Wenn die n-Kanal-Umladeschaltung 22 und die p-Kanal-Umladeschaltung 24 stromlos sind, wird am Abgriff 10 kein Strom eingespeist und auch kein Strom entnommen. Der Stromzweig 26 sowie der Stromzweig 28 sind dann ebenfalls stromlos. Dieser Zustand entspricht der normalen Arbeitsweise der Regelschleife, bei der beide oben genannten Signale übereinstimmen.

Unterschreitet dann die mit dem Filterausgang A verknüpfte Filterausgangsspannung VAM einen vorgegebenen Wert, z.B. ein Drittel der Betriebsspannung +Ub gegenüber Massepotential, so wird die n-Kanal-Umladeschaltung 22 wirksam. Die n-Kanal-Umladeschaltung 22 steuert den Stromzweig 26 wirksam, so daß ein Strom I9 gleichsinnig zum Ausgangsstrom der Filterschaltung 20 in den Knoten A fließen kann, der über die in Reihe geschalteten Kapazitäten C1, C2 eine Änderung der Filterausgangsspannung und damit auch des Potentials am Filterausgang A bewirken würde. Jedoch entnimmt die Umladeschaltung 22 am Abgriff 10 einen Strom I10, der parallel zur Teilkapazität C1 fließt und am Abgriff 10 einer Potentialänderung entgegen wirkt. Der Strom I9 in dem der Filterschaltung 20 parallel geschalteten Stromzweig 26 kann so bemessen werden, daß ein Spannungssprung z.B. beim Umschalten der Arbeitsfrequenz der PLL-Regelschleife die Filterausgangsspannung VAM nicht unter den vorstehend genannten Wert sinken läßt. Hat der Oszillator VCO seinen neuen Arbeitspunkt gefunden, so liegt die Filterausgangsspannung VAM wieder oberhalb des vorgegebenen Wertes, und die n-Kanal-Umladeschaltung wird stromlos. Der dann vorliegende Ladezustand der Kapazitäten C1, C2 wird beibehalten.

Bei einer Spannungsänderung der Filterausgangsspannung VA bzw. VAM in entgegengesetzter Richtung - also einem Anstieg des Potentials am Filterausgang A - wird die p-Kanal-Umladeschaltung 24 wirksam, sobald die Spannung VAM einen oberen vorgegebenen Wert, beispielsweise zwei Drittel der Betriebsspannung +Ub, erreicht. Die p-Kanal-Umladeschaltung 24 steuert den Stromzweig 28 an, so daß in ihm ein Strom 114 nach Masse fließt. Am Abgriff 10 wird ein Strom 120 eingespeist, um dort das Potential beizubehalten. Der Strom I14 ist so bemessen, daß die Filterausgangsspannung den oberen vorgegebenen Wert unterschreitet. Hat der Oszillator VCO seinen neuen Arbeitspunkt gefunden, so wird die p-Kanal-Umladeschaltung 24 stromlos. Der dann vorliegende Ladezustand der Kapazitäten C1 und C2 wird beibehalten.

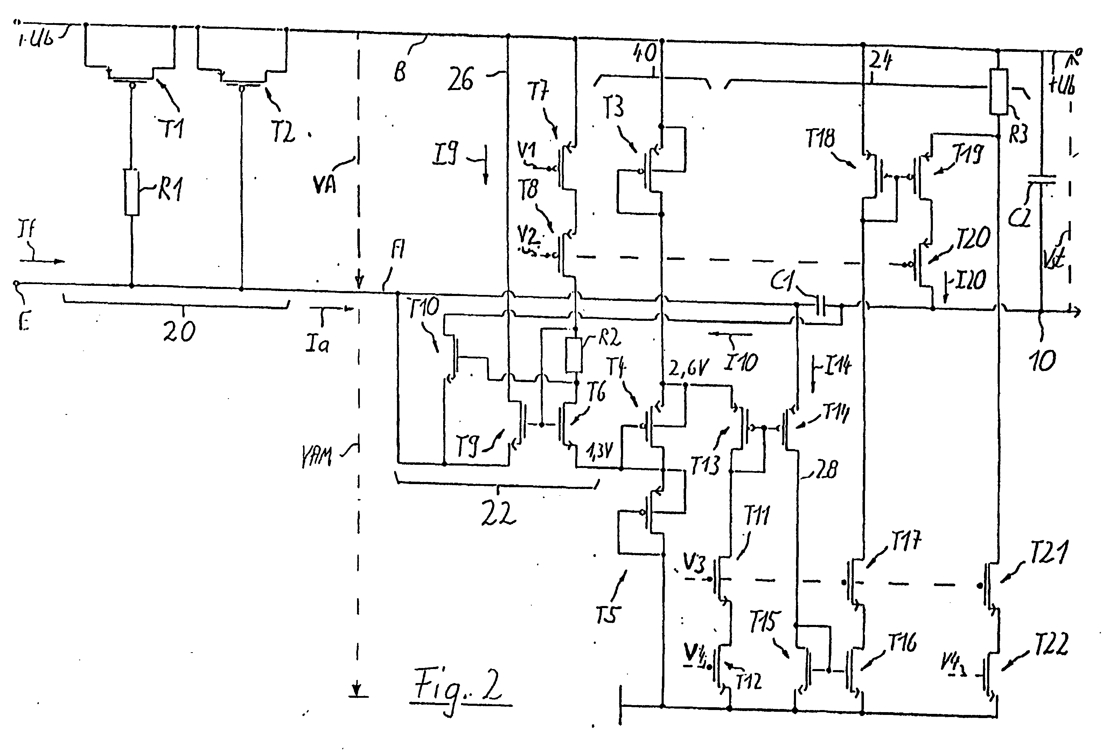

Fig. 2 zeigt eine nach dem in Fig. 1 dargestellten Prinzip arbeitende Schaltungsanordnung in integrierter MOS-Technik. Die Filterschaltung 20 enthält einen Widerstand R1, dessen einer Anschluß mit dem Eingangsanschluß E und dessen anderer Anschluß mit einem an positivem Betriebsspannungspotential liegenden und als Gateoxid-Kondensator geschalteten p-Kanal-Feldeffekttransistor T1 verbunden ist. Parallel zur Reihenschaltung des Widerstandes R1 und des Transistors T1 liegt ein ebenfalls als Gateoxid-Kondensator geschalteter p-Kanal-Feldeffekttransistor T2.

Der Ausgangsanschluß A der Filterschaltung 20 ist mit dem einen Anschluß des Kondensators C1 verbunden. Der andere Anschluß des Kondensators C1 bildet den Abgriff 10 des kapazitiven Spannungsteilers aus dem Kondensator C1 und dem mit dem positiven Betriebsspannungspotential +Ub verbundenen Kondensator C2. Am Abgriff 10 des kapazitiven Spannungsteilers C1, C2 erscheint das Steuerpotentíal Vst für den Oszillator VCO.

Die Schaltungsanordnung enthält im rechten Teil einen zwischen dem positiven Betriebsspannungspotential +Ub und Massepotential M liegenden Spannungsteiler 40. Dieser enthält drei in Reihe geschaltete p-Kanal-Feldeffekttransistoren T3, T4 und T5, die als gleichgroße Widerstände geschaltet sind. Dazu ist an den Transistoren T3, T4 und T5 jeweils der Gate-Anschluß mit dem Drain-Anschluß verbunden. Der Substratanschluß ist jeweils mit dem Source-Änschluß verbunden. Der Source-Anschluß des Transistors T3 liegt am positiven Betriebsspannungspotential +Ub. Der Drain-Anschluß des Transistors T3 ist mit dem Source-Anschluß des Transistors T4 verbunden. Der Drain-Anschluß des Transistors T4 ist mit dem Source-Anschluß des Transistors T5 verbunden. Der Drain-Anschluß des Transistors T5 liegt an Massepotential.

Die n-Kanal-Umladeschaltung 22 enthält Transistoren T6 bis T10. Die Transistoren T7 und T8 sind p-Kanal-Feldeffekttransistoren. Die Transistoren T6, T9 und T10 sind n-Kanal-Feldeffekttransistoren. Der Source-Anschluß des Transistors T6 ist mit dem Drain-Anschluß des Transistors T4 verbunden und liegt somit an einem Festpotential von etwa einem Drittel der Betriebsspannung Ub, also an 1,3 Volt gegenüber Massepotential bei 4 Volt Betriebsspannung. Der Drain-Anschluß des Transistors T6 ist mit einem Stromzweig verbunden, in dem mit Hilfe der Transistoren T7 und T8 ein vorgegebener Strom erzeugt wird. Dazu ist der Source-Anschluß des Transistors T7 mit dem positiven Betriebspotential +Ub verbunden. Der Transistor T8 bildet mit dem Transistor T7 eine Kaskade-Schaltung. Der Drain-Anschluß des Transistors T8 ist mit dem einen Anschluß eines ebenfalls zur n-Kanal-Umladeschaltung 22 gehörenden Widerstands R2 und mit den Gate-Anschlüssen der Transistoren T6 und T9 verbunden. Der andere Anschluß des Widerstands R2 ist mit dem Drain-Anschluß des Transistors T6 und mit dem Gate-Anschluß des Transistors T10 verbunden. Die Source-Anschlüsse der Transistoren T9 und T10 liegen am Ausgangsanschluß A der Filterschaltung 20. Der Drain-Anschluß des Transistors T9 ist mit dem positiven Betriebspotential +Ub verbunden, so daß er dem Filterausgang parallel geschaltet ist. Der Drain-Anschluß des Transistors T10 ist mit dem Abgriff 10 des kapazitiven Spannungsteilers C1, C2 verbunden, so daß die Arbeitsstrecke des Transistors T10 der Kapazität C1 parallel geschaltet ist.

Der Gate-Anschluß des Transistors T7 bzw. T8 wird mit einem Steuerpotential V1 bzw. V2 versorgt, das einerseits einen Drain-Strom in den Transistoren T7, T8 in der Größe des maximal zulässigen Filterausgangsstroms la fließen läßt und deren Temperaturgang andererseits so gewählt ist, daß die Spannung über dem Widerstand R2 bei jeder Betriebstemperatur einen Wert hat, der gewährleistet, daß das Stromspiegelungsverhältnis in den beiden stromspiegelähnlich arbeitenden Schaltungsanordnungen aus den Transistoren T6 und T9 bzw. T6 und T10 unabhängig von der Betriebstemperatur gleich bleibt. Die n-Kanal-Umladeschaltung 22 ist so ausgelegt, daß die Drain-Ströme der Transistoren T10 und T9 ein Verhältnis von 1:1000 haben.

Die p-Kanal-Umladeschaltung 24 enthält Transistoren T11 bis T20. Die Transistoren T13, T14 und T18 bis T20 sind p-Kanal-Feldeffekttransistoren. Die Transistoren T11, T12, T15 bis T17, T21 und T22 sind n-Kanal-Feldeffekttransistoren. Der Source-Anschluß des Transistors T13 ist mit dem Drain-Anschluß des Transistors T3 verbunden und liegt somit an einem Festpotential von etwa 2,6 Volt gegenüber Massepotential bei 4 Volt Betriebsspannung. Der Drain-Anschluß des Transistors T13 ist mit dessen Gate-Anschluß, mit dem Gate-Anschluß des Transistors T14 und mit dem Drain-Anschluß des Transistors T11 verbunden, der mit dem Transistor T12 eine Kaskode-Schaltung bildet. Der Source-Anschluß des Transistors T12 ist mit Massepotential verbunden. Der Source-Anschluß des Transistors T14 ist mit dem Ausgangsanschluß A der Filterschaltung 20 verbunden. Der Drain-Anschluß des Transistors T14 ist mit einer Stromspiegelschaltung aus den Transistoren T15, T16 und T17 verbunden. In dieser Stromspiegelschaltung arbeitet der Transistor T15 als Diode, wozu sein Gate-Anschluß und sein Drain-Anschluß verbunden sind. Die Gate-Anschlüsse der Transistoren T15 und T16 sind verbunden. Außerdem sind die Source-Anschlüsse der Transistoren T15 und T16 mit Massepotential verbunden. Die Transistoren T16 und T17 bilden eine Kaskode-Schaltung, so daß der Drain-Anschluß des Transistors T16 mit dem Source-Anschluß des Transistors T17 verbunden ist. Das Spiegelverhältnis der Ströme im Stromspiegel aus den Transistoren T15 bis T17 beträgt etwa 1:1.

Zum Stromspiegel aus den Transistoren T15 bis T17 ist ein weiterer Stromspiegel aus den Transistoren T18 bis T20 in Reihe geschaltet. Dazu ist der Drain-Anschluß des Transistors T17 mit dem Drain-Anschluß des Transistors T18 verbunden. Der Transistor T18 arbeitet als Diode, so daß sein Drain-Anschluß auch mit seinem Gate-Anschluß verbunden ist. Der Source-Anschluß des Transistors T18 liegt am positiven Betriebsspannungspotential +Ub. Der Gate-Anschluß des Transistors T18 ist außerdem mit dem Gate-Anschluß des Transistors T19 verbunden, der mit dem Transistor T20 eine Kaskode-Schaltung bildet. Der Source-Anschluß des Transistors T19 ist mit dem einen Anschluß eines Widerstands R3 und mit dem Drain-Anschluß des Transistors T21 verbunden. Der andere Anschluß des Widerstands R3 liegt am positiven Betriebspotential +Ub. Der Drain-Anschluß des Transistors T20 ist mit dem Abgriff 10 des kapazitiven Spannungsteilers C1, C2 verbunden. Der Gate-Anschluß des Transistors T20 liegt an dem Festpotential V2.

Der Transistor T21 bildet mit dem Transistor T22 eine Kaskode-Schaltung, wobei der Source-Anschluß des Transistors T22 mit Massepotential verbunden ist. Die Gate-Anschlüsse der Transistoren T11, T17 und T21 liegen an einem Festpotential V3, und die Gate-Anschlüsse der Transistoren T12 und T22 liegen an einem Festpotential V4. Die Festpotentiale V3 und V4 haben einen Temperaturgang, der unabhängig von der Betriebstemperatur gleiche Stromspiegelverhältnisse in den Stromspiegeln T15 bis T17 und T18 bis T20 ermöglicht. Insbesondere haben die Festpotentiale V3 und V4 einen Temperaturgang, der den Spannungsabfall an dem Widerstand R3 so verändert, daß der Stromspiegel T18 bis T19 unabhängig von der Betriebstemperatur ein gleichbleibendes Stromspiegelverhältnis von etwa 1000:1 zwischen Eingangsstrom und Ausgangsstrom hat.

Im folgenden soll die Funktion der n-Kanal-Umladeschaltung 22 erläutert werden. Die Transistoren T6 und T9 bilden eine erste stromspiegelähnliche Schaltung, die sich von bekannten Stromspiegelschaltungen dadurch unterscheidet, daß die Source-Anschlüsse der Transistoren T6 und T9 nicht verbunden sind. Dadurch wird erreicht, daß die Schaltung aus den Transistoren T6 und T9 erst wirksam wird, wenn das Potential am Filterausgang A unter den vorgegebenen Wert von 1,3 Volt am Source-Anschluß des Transistors T6 fällt. Erst bei diesem Wert des Potentials am Filterausgang A hat der Drain-Strom des Transistors T9 einen Wert, der etwa dem Drain-Strom des Transistors T6 entspricht. Sinkt die Filterausgangsspannung VAM weiter, so wird ein entsprechend größerer Drain-Strom I9 erzeugt.

Die Transistoren T6 und T10 bilden ebenfalls eine solche stromspiegelartige Schaltung. Jedoch ist der Drain-Strom des Transistors T10 aufgrund einer im Vergleich zur Gate-Source-Spannung des Transistors T9 geringeren Gate-Source-Spannung wesentlich kleiner als der Drain-Strom I9 im Transistor T9. Während also die Ströme I9 und I10 in der n-Kanal-Umladeschaltung 22 im normalen Betriebszustand vernachlässigbar klein sind, haben sie bei einer GrenzwertÜberschreitung der Filterausgangsspannung VA die vorgegebenen Werte. Der Strom I10 ist so bemessen, daß er mit kleiner werdendem Potential am Filterausgang A ansteigt. Somit verändert sich das Potential am Abgriff 10 stärker, wenn das Potential am Filterausgang A stärker unter den Wert von 1,3 Volt fällt. Dies ermöglicht eine schnelle und präzise Regelung des Potentials am Abgriff 10 im Vergleich zum Abgriff eines konstanten Stroms. Der Strom I9 wird ebenfalls mit sinkender Filterausgangsspannung VAM größer, so daß das Verhältnis von I9 und I10 über den gesamten Aussteuerbereich gesichert ist.

Damit der n-Kanal-Transistor T10 nur durch den Ausgang A der Filterschaltung und nicht vom Abgriff 10 des Spannungsteilers gesteuert wird, muß der Abgriff 10 positiv gegen den Ausgang A vorgespannt sein. Wenn das nicht möglich ist, muß auch für die n-Kanal-Umladeschaltung eine Schaltung nach Art der p-Kanal-Umladeschaltung in komplementärer Weise verwendet werden.

Die p-Kanal-Umladeschaltung 24 arbeitet auf ähnliche Weise. Jedoch soll sie einen Ladestrom 120 am Abgriff 10 des kapazitiven Spannungsteilers C1, C2 einspeisen. Deshalb ist eine Potentialerhöhung notwendig, die mit Hilfe der beiden Stromspiegel T15 bis T17 und T18 bis T20 erfolgt. Die Transistoren T13 und T14 bilden ebenfalls eine stromspiegelähnliche Schaltung, die beim Überschreiten des am Source-Anschluß des Transistors T13 liegenden Festpotentialwertes von 2,6 Volt arbeitet. Am Abgriff 10 wird der Strom 120 eingespeist, um das Potential am Abgriff 10 anzuheben.

Unterschreitet das Potential am Filterausgang A den oberen Festpotentialwert, werden die Ströme I14 und 120 vernachlässigbar klein, da die p-Kanal-Umladeschaltung 24 wieder im Ruhezustand ist.

Die Kapazität C2 hat nur etwa ein Zehntel des Kapazitätswertes der durch den Transistor T1 gebildeten Kapazität. Bei einem Spannungsteilerverhältnis im kapazitiven Spannungsteiler C1 und C2 von 100:1 und dem erwähnten Stromverhältnis von 1000:1 ist gewährleistet, daß das Verhältnis des Stroms If bzw. la zur Änderung des Potentials am Abgriff 10 in allen Betriebsarten der Schaltungsanordnung etwa denselben Wert hat. Dies führt zu einem guten Regelverhalten in einer PLL-Regelschleife.

Bei einem anderen Ausführungsbeispiel wird anstelle der n-Kanal-Umladeschaltung 22 eine Umladeschaltung verwendet, die zur p-Kanal-Umladeschaltung 24 komplementär ist. Das bedeutet, daß anstelle von p-Kanal-Transistoren n-Kanal-Transistoren verwendet werden. Anstelle von n-Kanal-Transistoren werden p-Kanal-Transistoren verwendet. Außerdem werden Transistoren, die in der p-Kanal-Umladeschaltung 24 gegen Masse geschaltet sind, gegen die positive Versorgungsspannung +Ub geschaltet. Transistoren, die in Figur 2 gegen die positive Versorgungsspannung +Ub geschaltet sind, werden bei diesem Ausführungsbeispiel in der Umladeschaltung 22 gegen Massepotential geschaltet. Ausgehend von dem in Figur 2 gezeigten Transistor T6 hätte die Umladeschaltung 22 dann einen Stromzweig mit vorgegebenem Stromfluß in der Arbeitsstrecke des Transistors T6. Der eine Arbeitsstreckenanschluß des Transistors T6 würde weiterhin auf dem Festpotential von 1,3 Volt liegen. Der Steueranschluß des Transistors T6 wäre mit dem anderen Arbeitsstreckenanschluß und mit dem Steueranschluß des Transistors T9 verbunden. Der eine Arbeitsstreckenanschluß des Transistors T9 wäre, wie auch in Figur 2 mit dem einen Ausgangsanschluß A der Filterschaltung 20 verbunden. Der andere Arbeitsstreckenanschluß des Transistors T9 wäre mit dem Eingangsstromzweig zweier in Serie geschalteter Stromspiegelschaltungen verbunden. Der Ausgangsstromzweig der zweiten Stromspiegelschaltung wäre mit dem Abgriff 10 des Spannungsteilers C1, C2 direkt und mit dem Massepotential über einen weiteren Widerstand verbunden, der mit einem vorgegebenen Strom aus einem weiteren Stromzweig gespeist wird.

## Patentansprüche

1. Schaltungsanordnung zum Erzeugen des Steuerpotentials (Vst) für einen Feldeffekttransistor aus der Ausgangsspannung (VA) einer Filterschaltung (20),
bei der die Ausgangsspannung (VA, VAM) der Filterschaltung (20) auf einen kapazitiven Spannungsteiler (C1, C2) geführt ist, dessen Abgriff (10) das Steuerpotential (Vst) führt,
wobei die Schaltungsanordnung den Ladezustand des Spannungsteilers (C1, C2) zum Einstellen eines vorbestimmten Potentialwertes des Steuerpotentials (Vst) gegenüber dem Bezugspotential des Feldeffekttransistors durch Einspeisen eines Umladestroms (I10, I20) am Abgriff (10) des Spannungsteilers (C1, C2) steuert, bis der vorbestimmte Potentialwert erreicht ist,
die Schaltungsanordnung Mittel enthält, die die Filterausgangsspannung (VA, VAM) erfassen,
und wobei die Schaltungsanordnung eine den Umladestrom (I10, I20) liefernde Schaltung (22, 24) enthält, die beim Abweichen der Filterausgangsspannung (VA, VAM) von mindestens einem vorgegebenen Wert den Umladestrom (I10, I20) erzeugt,
**dadurch gekennzeichnet, daß** die den Umladestrom (I10, I20) liefernde Schaltung (22, 24) während des betragsmäßigen Über- bzw. Unterschreitens einer vorgegebenen oberen bzw. unteren Filterausgangsspannung (VA, VAM) ein mit dem Filterausgang (A) verbundener Stromzweig (26 bzw. 28) wirksam steuert, der den Filterausgang (A) mit einem die Filterausgangsspannung (VA, VAM) betragsmäßig verkleinernden bzw. betragsmäßig vergrößernden Strom (I9, I14) belastet,
und daß das Stromverhältnis von Umladestrom und dem Strom im mit dem Filterausgang (A) verbundenen Stromzweig (26 bzw. 28) so bemessen ist, daß eine Änderung eines Stroms (If) am Eingang bzw. eines Stroms (la) am Ausgang der Filterschaltung (20) eine Änderung des Potentials am Abgriff (10) des Spannungsteilers (C1, C2) in allen Betriebsarten der Schaltungsanordnung um etwa denselben Wert bewirkt.

2. Schaltungsanordnung **dadurch gekennzeichnet, daß** der vorgegebene Wert fest gegenüber einem Massepotential und/oder einem Versorgungspotential (+Ub) vorgegeben ist.

3. Schaltungsanordnung nach Anspruch 2, **dadurch gekennzeichnet, daß** während des betragsmäßigen Über- bzw. Unterschreitens einer vorgegebenen oberen bzw. unteren Filterausgangsspannung (VA, VAM) ein mit dem Filterausgang (A) verbundener Stromzweig (26 bzw. 28) wirksam steuerbar ist, der den Filterausgang (A) mit einem die Filterausgangsspannung (VA, VAM) betragsmäßig verkleinernden bzw. betragsmäßig vergrößernden Strom (I9, I14) belastet.

4. Schaltungsanordnung nach Anspruch 3, **dadurch gekennzeichnet, daß** das Stromverhältnis von Umladestrom und dem Strom im mit dem Filterausgang (A) verbundenen Stromzweig (26 bzw. 28) so bemessen ist, daß das Verhältnis eines Stroms (If) am Eingang bzw. eines Stroms (la) am Ausgang der Filterschaltung (20) und der Änderung des Potentials am Abgriff (10) des Spannungsteilers (C1, C2) in allen Betriebsarten der Schaltungsanordnung etwa denselben Wert hat.

5. Schaltungsanordnung nach Anspruch 1 oder 4, **dadurch gekennzeichnet, daß** der Umladestrom (I10, I20) und der Strom im mit dem Filterausgang (A) verbundenen Stromzweig (26, 28) in einem vorgegebenen Stromverhältnis stehen, das kleiner als 1:10, vorzugsweise 1:1000 ist.

6. Schaltungsanordnung nach einem der vorhergehenden Ansprüche, **dadurch gekennzeichnet, daß** die Richtung des Ladestroms (I10, I20) durch die erforderliche Einstellrichtung zum vorbestimmten Potentialwert (Vst) hin vorgegeben ist.

7. Schaltungsanordnung nach einem der vorhergehenden Ansprüche, **dadurch gekennzeichnet, daß** eine n-Kanal-Umladeschaltung (22) einen Stromzweig mit vorgegebenem Stromfluß in der Arbeitsstrecke eines ersten Transistors (T6) enthält, dessen einer Arbeitsstreckenanschluß auf einem ersten Festpotential liegt, daß der Stromzweig einen Widerstand (R2) enthält, dessen einer Anschluß mit dem anderen Arbeitsstreckenanschluß des ersten Transistors (T6) und dem Steueranschluß eines zweiten Transistors (T10) verbunden ist, dessen Arbeitsstrecke mit einem Ausgangsanschluß (A) der Filterschaltung (20) und dem Abgriff des Spannungsteilers (C1, C2) verbunden ist, und daß der andere Anschluß des Widerstands (R2) mit dem Steueran
schluß des ersten Transistors (T6) und dem Steueranschluß eines dritten Transistors (T9) verbunden ist, dessen Arbeitsstrecke an der Filterausgangsspannung (VA) liegt.

8. Schaltungsanordnung nach einem der vorhergehenden Ansprüche, **dadurch gekennzeichnet, daß** eine Umladeschaltung (24) einen Stromzweig mit vorgegebenem Stromfluß in der Arbeitsstrecke eines vierten Transistors (T13) enthält, dessen einer Arbeitsstreckenanschluß auf einem zweiten Festpotential liegt, daß der Steueranschluß des vierten Transistors (T13) mit dessen anderem Arbeitsstreckenanschluß und mit dem Steueranschluß eines fünften Transistors (T14) verbunden ist, daß der eine Arbeitsstreckenanschluß des fünften Transistors (T14) mit einem Ausgangsanschluß (A) der Filterschaltung (20) und der andere Arbeitsstreckenanschluß des fünften Transistors (T14) mit dem Eingangsstromzweig zweier in Serie geschalteter Stromspiegelschaltungen (T15 bis T17, T18 bis T20) verbunden ist, und daß der Ausgangsstromzweig der zweiten Stromspiegelschaltung (T18 bis T20) mit dem Abgriff (10) des Spannungsteilers (C1, C2) direkt und mit dem zweiten Ausgangsanschluß (+Ub) der Filterschaltung (20) oder einem Masseanschluß über einen weiteren Widerstand (R3) verbunden ist, der mit einem vorgegebenen Strom aus einem weiteren Stromzweig (T21, T22) gespeist wird.

9. Schaltungsanordnung nach einem der vorhergehenden Ansprüche, **dadurch gekennzeichnet, daß** die Filterschaltung (20) ein Schleifenfilter in einer Phasenregelschleife ist, und daß der Feldeffekttransistor der Eingangstransistor eines spannungsgesteuerten Oszillators (VCO) der Phasenregelschaltung ist.

10. Schaltungsanordnung nach einem der vorhergehenden Ansprüche, **dadurch gekennzeichnet, daß** ein vorgegebener Wert im wesentlichen nicht größer als ein Drittel der Betriebsspannung und/oder ein anderer vorgegebener Wert, im wesentlichen nicht kleiner als zwei Drittel der Betriebsspannung betragen.

11. Schaltungsanordnung nach einem der vorhergehenden Ansprüche, **dadurch gekennzeichnet, daß** der vorgegebene Wert durch einen Spannungsteiler (T3, T4, T5) erzeugt wird.

12. Schaltungsanordnung nach einem der vorhergehenden Ansprüche, **dadurch gekennzeichnet, daß** der kapazitive Spannungsteiler (C1, C2) die Ausgangsspannung (VA) der Filterschaltung (20) mindestens im Verhältnis 10:1 kapazitiv aufteilt.

13. Schaltungsanordnung nach Anspruch 12, **dadurch gekennzeichnet, daß** das Spannungsverhältnis 100:1 beträgt.

14. Schaltungsanordnung nach einem der vorhergehenden Ansprüche, **dadurch gekennzeichnet, daß** die vorgegebene obere bzw. untere Filterausgangsspannung (VA) positive Spannungen sind,
und daß während des Über- bzw. Unterschreitens der vorgegebenen oberen bzw. unteren Filterausgangsspannung (VA) der mit dem Filterausgang (A) verbundene Stromzweig (26 bzw. 28) so wirksam steuerbar ist, daß er den Filterausgang (A) mit einem die Filterausgangsspannung (VA) absenkenden bzw. anhebenden Strom (I9, I14) belastet.

## Claims

1. A circuit arrangement for generating the control potential (Vst) for a field-effect transistor from the output voltage (VA) of a filter circuit (20),
in which the output voltage (VA, VAM) of the filter circuit (20) is passed to a capacitive voltage divider (C1, C2), whose tap (10) carries the control potential (Vst),
the circuit arrangement controlling the charge state of the voltage divider (C1, C2) for setting a predetermined potential value of the control value (Vst) relative to the reference potential of the field-effect transistor by a charge-reversal current (I10, I20) being fed in at said tap (10) of said voltage divider (C1, C2), until said predetermined potential value is reached, the circuit arrangement comprising means detecting the filter output voltage (VA, VAM),
and the circuit assembly including a circuit (22, 24) supplying the charge-reversal current (I10, I20) and generating said charge-reversal current (I10, I20) in the event of said filter output voltage (VA, VAM) deviating from at least one prescribed value,
**characterized in that** while the magnitude of a prescribed upper or lower filter output voltage (VA, VAM) is respectively exceeded or undershot, said circuit (22, 24) supplying said charge-reversal current (110, 120) activates a current branch (26 or 28) connected to the filter output (A), which loads the filter output (A) with a current (I9, I14) that respectively decreases or increases the magnitude of the filter output voltage (VA, VAM),
and **in that** the current ratio between charge-reversal current and the current in the current branch (26 or 28) connected to the filter output (A) is dimensioned in such a way that a change of a current (If) at the input or a current (Ia) at the output of said filter circuit (20), respectively, provokes a change at the tap (10) of the voltage divider (C1, C2) by approximately the same value in all operating modes of the circuit arrangement.

2. A circuit arrangement, **characterized in that** said prescribed value is fixedly prescribed relative to a ground potential and/or a supply potential (+Ub).

3. The circuit arrangement according to claim 2, **characterized in that** while the magnitude of a prescribed upper or lower filter output voltage (VA, VAM) is exceeded or undershot, a current branch (26 or 28) connected to the filter output (A) can be activated, which current branch loads the filter output (A) with a current (I9, I14) that respectively decreases or increases the magnitude of the filter output voltage (VA, VAM).

4. The circuit arrangement according to claim 3, **characterized in that** said current ratio between charge-reversal current and the current in the current branch (26 or 28) connected to the filter output (A) is dimensioned in such a way that the ratio between a current (If) at the input or a current (Ia) at the output of said filter circuit (20), respectively, and the change in potential at the tap (10) of the voltage divider (C1, C2) has approximately the same value in all operating modes of the circuit arrangement.

5. The circuit arrangement according to claims 1 or 4, **characterized in that** said charge-reversal current (I10, I20) and said current in said current branch (26, 28) connected to said filter output (A) are in a prescribed current ratio which is less than 1:10, preferably 1:1000.

6. The circuit arrangement according to any of the preceding claims, **characterized in that** the direction of the charging current (I10, I20) is prescribed by the required setting direction toward the predetermined potential value (Vst).

7. The circuit arrangement according to any of the preceding claims, **characterized in that** an n-channel charge-reversal current (22) contains a current branch with a prescribed current flow in the operating path of a first transistor (T6), one of whose operating path terminals is at a first fixed potential, **in that** the current branch contains a resistor (R2), one of whose terminals is connected to the other operating path terminal of the first transistor (T6) and to the control terminal of a second transistor (T10), whose operating path is connected to an output terminal (A) of the filter circuit (20) and the tap of the voltage divider (C1, C2), and **in that** the other terminal of the resistor (R2) is connected to the control terminal of the first transistor (T6) and to the control terminal of a third transistor (T9), whose operating path is at the filter output voltage (VA).

8. The circuit arrangement according to any of the preceding claims, **characterized in that** a charge-reversal circuit (24) contains a current branch with a prescribed current flow in the operating path of a fourth transistor (T13), one of whose operating path terminals is at a second fixed potential, **in that** the control terminal of the fourth transistor (T13) is connected to the other operating path thereof and to the control terminal of a fifth transistor (T14), **in that** one operating path terminal of the fifth transistor (T14) is connected to an output terminal (A) of the filter circuit (20) and the other operating path terminal of the fifth transistor (T14) is connected to the input current branch of two series-connected current mirror circuits (T15 to T17, T18 to T20), and **in that** the output current branch of the second current mirror circuit (T18 to T20) is connected to the tap (10) of the voltage divider (C1, C2) directly and to the second output terminal (+Ub) of the filter circuit (20) or to a ground terminal via a further resistor (R3), which is fed with a prescribed current from a further current branch (T21, T22).

9. The circuit arrangement according to any of the preceding claims, **characterized in that** said filter circuit (20) is a loop filter in a phase-locked loop, and **in that** said field-effect transistor is the input transistor of a voltage-controlled oscillator (VCO) of the phase-regulating circuit.

10. The circuit arrangement according to any of the preceding claims, **characterized in that** a prescribed value is substantially not higher than one third of the operating voltage and/or another prescribed value is substantially not smaller than two thirds of the operating voltage.

11. The circuit arrangement according to any of the preceding claims, **characterized in that** said prescribed value is produced by a voltage divider (T3, T4, T5).

12. The circuit arrangement according to any of the preceding claims, **characterized in that** said capacitive voltage divider (C1, C2) capacitively divides the output voltage (VA) of the filter circuit (20) at least in the ratio of 10:1.

13. The circuit arrangement according to claim 12, **characterized in that** said voltage ratio is 100:1.

14. The circuit arrangement according to any of the preceding claims, **characterized in that** said prescribed upper or lower filter output voltages (VA), respectively, are positive voltages,
and **in that** while a prescribed upper or lower filter output voltage (VA) is respectively exceeded or undershot, the current branch (26 or 28) connected to the filter output (A) can be activated such that it loads the filter output (A) with a current (I9, I14) which respectively decreases or increases the filter output voltage (VA).

## Revendications

1. Agencement de circuit destiné à générer le potentiel de commande (Vst) d'un transistor à effet de champ à partir de la tension de sortie (VA) d'un circuit de filtrage (20), dans lequel :
la tension de sortie (VA, VAM) du circuit de filtrage (20) est appliquée à un diviseur de tension capacitif (C1, C2) dont la borne (10) porte le potentiel de commande (Vst),
dans lequel l'agencement de circuit commande l'état de charge du diviseur de tension (C1, C2) en vue de régler une valeur de potentiel prédéterminée du potentiel de commande (Vst) par rapport au potentiel de référence du transistor à effet de champ en fournissant un courant d'inversion de charge (I10, I20) au niveau de la borne (10) du diviseur de tension (C1, C2) jusqu'à atteindre la valeur de potentiel prédéterminée,
l'agencement de circuit comporte des moyens qui mesurent la tension de sortie de filtre (VA, VAM), et
et dans lequel l'agencement de circuit comporte un circuit (22, 24) délivrant le courant d'inversion de charge (I10, I20), qui génère le courant d'inversion de charge (I10, I20) lorsque la tension de sortie de filtre (VA, VAM) s'écarte d'au moins une valeur prédéterminée,
**caractérisé en ce que** le circuit (22, 24) délivrant le courant d'inversion de chargé (I10, I20) commande efficacement, pendant le dépassement en valeur absolue vers le haut resp. vers le bas d'une tension de sortie de filtre (VA, VAM) supérieure resp. inférieure prédéterminée, une branche de courant (26 resp. 28) qui est reliée à la sortie de filtre (A) et qui attaque la sortie de filtre (A) avec un courant (I9, I14) augmentant ou diminuant en valeur absolue la tension de sortie de filtre (VA, VAM),
et **en ce que** le rapport entre le courant d'inversion de charge et le courant dans la branche de courant (26 resp. 28) reliée à la sortie de filtre (A) est dimensionné de telle sorte qu'une variation d'un courant (If) à l'entrée resp. d'un courant (Ia) en sortie du circuit de filtrage (20) provoque une variation, de sensiblement la même valeur, du potentiel au niveau de la borne (10) du diviseur de tension (C1, C2) dans tous les modes de fonctionnement de l'agencement de circuit.

2. Agencement de circuit, **caractérisé en ce que** la valeur prédéterminée est prédéterminée pour être fixe par rapport à un potentiel, de masse et/ou un potentiel d'alimentation (+Ub)

3. Agencement de circuit selon la revendication 2, **caractérisé en ce que**, pendant le dépassement en valeur absolue vers le haut resp. vers le bas d'une tension de sortie de filtre (VA, VAM) supérieure resp. inférieure prédéterminée, une branche de courant (26 resp. 28) reliée à la sortie de filtre (A) peut être commandée efficacement, laquelle branche de courant attaque la sortie de filtre (A) avec un courant (I9, I14) augmentant ou diminuant en valeur absolue la tension de sortie de filtre (VA, VAM).

4. Agencement de circuit selon la revendication 3, **caractérisé en ce que** le rapport entre le courant d'inversion de charge et le courant dans la branche de courant (26 resp. 28) reliée à la sortie de filtre (A) est dimensionné de telle sorte que le rapport entre un courant (If) à l'entrée resp. un courant (Ia) en sortie du circuit de filtrage (20), et la variation du potentiel au niveau de la borne (10) du diviseur de tension (C1, C2) a sensiblement la même valeur dans tous les modes de fonctionnement de l'agencement de circuit.

5. Agencement de circuit selon la revendication 1 ou 4, **caractérisé en ce que** le courant d'inversion de charge (I10, I20) et le courant dans la branche de courant (26, 28) reliée à la sortie de filtre (A) sont dans un rapport de courant prédéterminé qui est inférieur à 1:10, et de préférence 1:1000.

6. Agencement de circuit selon l'une des revendications précédentes, **caractérisé en ce que** le sens du courant de charge (I10, I20) est prédéterminé par le sens de réglage nécessaire par rapport à la valeur de potentiel prédéterminée (Vst).

7. Agencement de circuit selon l'une des revendications précédentes, **caractérisé en ce qu'**un circuit d'inversion de charge à canal n (22) comporte une branche de courant présentant une conduction de courant prédéterminée dans la section de travail d'un premier transistor (T6) dont une borne de section de travail est à un premier potentiel fixe, **en ce que** la branche de courant comporte une résistance (R2) dont une borne est reliée à l'autre borne de section de travail du premier transistor (T6) et à la borne de commande d'un deuxième transistor (T10) dont la section de travail est reliée à une borne de sortie (A) du circuit de filtrage (20) et à la borne du diviseur de tension (C1, C2), et **en ce que** l'autre borne de la résistance (R2) est reliée à la borne de commande du premier transistor (T6) et à la borne de commande d'un troisième transistor (T9) dont la section de travail est à la tension de sortie de filtre (VA).

8. Agencement de circuit selon l'une des revendications précédentes, **caractérisé en ce qu'**un circuit d'inversion de charge (24) comporte une branche de courant présentant une conduction de courant prédéterminée dans la section de travail d'un quatrième transistor (T13) dont une borne de section de travail est à un deuxième potentiel fixe, **en ce que** la borne de commande du quatrième transistor (T13) est reliée à l'autre borne de section de travail du quatrième transistor (T13) et à la borne de commande d'un cinquième transistor (T14), **en ce qu'**une borne de section de travail du cinquième transistor (T14) est reliée à une borne de sortie (A) du circuit de filtrage (20) et l'autre borne de section de travail du cinquième transistor (T14) est reliée à la branche de courant d'entrée de deux circuits de courant en miroir (T15 à T17, T18 à T20) montés en série, et **en ce que** la branche de courant de sortie du deuxième circuit de courant en miroir (T18 à T20) est reliée à la borne (10) du diviseur de tension (C1, C2) directement et à la deuxième borne de sortie (+Ub) du circuit de filtrage (20) ou à une borne de masse via une autre résistance (R3) qui est traversée par un courant prédéterminé provenant d'une autre branche de courant (T21, T22).

9. Agencement de circuit selon l'une des revendications précédentes, **caractérisé en ce que** le circuit de filtrage (20) est un filtre de boucle dans une boucle d'asservissement en phase, et **en ce que** le transistor à effet de champ est le transistor d'entrée d'un oscillateur commandé en tension (VCO) du circuit d'asservissement en phase.

10. Agencement de circuit selon l'une des revendications précédentes, **caractérisé en ce qu'**une valeur prédéterminée n'est sensiblement pas supérieure à un tiers de la tension de fonctionnement et/ou une autre valeur prédéterminée n'est sensiblement pas inférieure aux deux tiers de la tension de fonctionnement.

11. Agencement de circuit selon l'une des revendications précédentes, **caractérisé en ce que** la valeur prédéterminée est générée par un diviseur de tension (T3, T4, T5).

12. Agencement de circuit selon l'une des revendications précédentes, **caractérisé en ce que** le diviseur de tension capacitif (C1, C2) divise du point de vue capacitif la tension de sortie (VA) du circuit de filtrage (20) au moins dans un rapport 10:1.

13. Agencement de circuit selon la revendication 12, **caractérisé en ce que** le rapport de tension est 100:1.

14. Agencement de circuit selon l'une des revendications précédentes, **caractérisé en ce que** la tension de sortie de filtre (VA) supérieure resp. inférieure prédéterminée est une tension positive, et **en ce que** la branche de courant (26 resp. 28) reliée à la sortie de filtre (A) peut être commandée efficacement pendant le dépassement vers le haut resp. vers le bas de la tension de sortie de filtre (VA) supérieure resp. inférieure, de façon à attaquer la sortie de filtre (A) avec un courant (I9, I14) diminuant resp. augmentant la tension de sortie de filtre (VA).
